# EUROPÄISCHE PATENTSCHRIFT

(11) **EP 3 044 635 B1**
(45) Veröffentlichungstag und Bekanntmachung des Hinweises auf die Patenterteilung: **11.08.2021**
(21) Anmeldenummer: 14755086.7
(22) Anmeldetag: 25.08.2014
(51) Int. Cl.: G03F 7/20, G21K 1/06, G02B 19/00, G02B 5/09

(54) **KOLLEKTOR**
COLLECTOR
COLLECTEUR

(30) Priorität: 11.09.2013 DE 102013218132
(43) Veröffentlichungstag der Anmeldung: 20.07.2016
(73) Patentinhaber: Carl Zeiss SMT GmbH, 73447 Oberkochen (DE)
(72) Erfinder: DEGÜNTHER, Markus, 73432 Aalen (DE)
(74) Vertreter: Rau, Schneck & Hübner Patentanwälte Rechtsanwälte PartGmbB
(86) Internationale Anmeldenummer: PCT/EP2014/067963
(87) Internationale Veröffentlichungsnummer: WO 2015/036228

(56) Entgegenhaltungen:
- DE-A1- 10 138 313
- DE-A1-102009 045 135
- US-A1- 2013 022 901
- US-B1- 6 285 737

## Beschreibung

Die Erfindung betrifft ein Beleuchtungssystem mit einer Beleuchtungsoptik, die von einem Kollektor gesammeltes EUV-Beleuchtungslicht hin zu einem Objektfeld führt. Ferner betrifft die Erfindung einen Kollektor zur Überführung von EUV-Beleuchtungslicht aus einen Strahlungsquellenbereich hin zu einer Beleuchtungsoptik, eine Projektionsbelichtungsanlage mit einem derartigen Beleuchtungssystem, ein Verfahren zur Herstellung eines mikro- beziehungsweise nanostrukturierten Bauelements mit einer derartigen Projektionsbelichtungsanlage und ein mit dem Verfahren hergestelltes Bauelement.

Kollektoren der eingangs genannten Art sind bekannt aus der US 6,507,440 B1, der DE 10 2010 063 530 A1, der WO 2011/138259 A1, aus der US 7,075,712 B2, der US 7,501,641 B2, der US 2006/0176547 A1, der US 2006/0120429 A1, der US 7,075,713 B2, der EP 1 469 349 A1, der US 2008/0266650 A1, der WO 2007/045 434 A2, der US 6,438,199 B1, der US 5,339,346 A, der EP 1 650 786 B1, der DE 10 2011 084 266 A und der WO 2013/053 692 A. Mikrolithografische Verfahren zur Herstellung mikrostrukturierter Bauteile sind bekannt aus der US 2013/0022901 A1, der DE 10 2009 045 135 A1, der DE 101 38 313 A1 und der US 6,285,737 B1.

Es ist eine Aufgabe der vorliegenden Erfindung, einen Kollektor der eingangs genannten Art, insbesondere als Teil eines Beleuchtungssystems, derart weiterzubilden, dass eine effiziente Überführung des EUV-Beleuchtungslichts in ein Beleuchtungs- beziehungsweise Objektfeld gewährleistet ist.

Die Aufgabe ist erfindungsgemäß gelöst durch ein Beleuchtungssystem mit den im Anspruch 1 angegebenen Merkmalen sowie durch einen Kollektor mit den im Anspruch 2 angegebenen Merkmalen

Durch die erfindungsgemäße Anpassung der Abbildungsmaßstäbe der Kollektor-Abbildungsoptik an die von der Strahlungsquelle emittierten Strahlwinkel des EUV-Beleuchtungslichts ergibt sich eine vorteilhaft niedrige Variation eines Querschnitts des nachgelagerten Fokusbereiches. Dies ermöglicht eine Pupillenausleuchtung eines dem Kollektor nachgeordneten Beleuchtungssystems mit vorteilhaft hoher Pupillenfüllung. Bei dem Beleuchtungssystem wird eine Maßstabsvariation bei der Abbildung des Strahlungsquellenbereiches über einen zwischengeschalteten nachgelagerten Fokusbereich auf die Pupillenfacetten zwischen der Kollektor-Abbildungsoptik und der Feldfacetten-Übertragungsoptik so aufgeteilt, dass eine Maßstabsvariation der Gesamtabbildung vorteilhaft klein gehalten ist. Das Produkt zwischen den Kollektor-Abbildungsmaßstäben und den zugehörigen Facetten-Abbildungsmaßstäben kann sich für alle Lichtwege des Beleuchtungslichts hin zu den Pupillenfacetten um nicht mehr als einen Faktor 2,25, um nicht mehr als einen Faktor 2,0, um nicht mehr als einen Faktor 1,9, um nicht mehr als einen Faktor 1,8, um nicht mehr als einen Faktor 1,7, um nicht mehr als einen Faktor 1,6 oder auch um nicht mehr als einen Faktor 1,5 oder sogar um nicht mehr als einen Faktor 1,25 unterscheiden. Es resultieren Vorteile, die auch im Zusammenhang mit dem Kollektor erläutert werden.

Bei den Abbildungsmaßstäben, die vorstehend im Zusammenhang mit der Lösung der Aufgabe diskutiert wurden, handelt es sich um für einen Bereich von Strahlwinkeln jeweils gemittelten Abbildungsmaßstab. Bei dem Abbildungsmaßstab handelt es sich um einen Flächenabbildungsmaßstab. Der Kollektor kann zur Führung des EUV-Beleuchtungslichts mit Einfallswinkeln kleiner als 45°, also als Kollektor für im Wesentlichen normalen Einfall des Beleuchtungslichts (normal incidence, NI) ausgeführt sein. Einfallswinkel des Beleuchtungslichts auf dem Kollektor können kleiner sein als 40°, kleiner als 35°, kleiner als 30°, kleiner als 25°, kleiner als 22,5° oder kleiner als 20°. Insbesondere können alle Einfallswinkel auf dem Kollektor kleiner sein als die vorstehend beschriebenen oberen Grenzwerte.

Die Abbildungsmaßstäbe für Strahlwinkel einerseits kleiner als 20° und Strahlwinkel andererseits größer als 70° können sich beim erfindungsgemäßen Kollektor um nicht mehr als einen Faktor 2,25, um nicht mehr als einen Faktor 2,0, um nicht mehr als einen Faktor 1,9, um nicht mehr als einen Faktor 1,8, um nicht mehr als einen Faktor 1,7, um nicht mehr als einen Faktor 1,6, um nicht mehr als einen Faktor 1,5 und sogar um nicht mehr als einen Faktor 1,25 unterscheiden.

Bei einem Kollektor nach Anspruch 3 wird eine Variation eines Abbildungsmaßstabes durch die Kollektor-Abbildungsspiegeln gezielt minimiert und dies sorgt für eine Vereinheitlichung einer Querschnittsausdehnung des nachgelagerten Fokusbereiches. Das Verhältnis zwischen dem maximalen und dem minimalen Abbildungsmaßstab jedes Kollektor-Abbildungsspiegels kann höchsten 1,9 betragen, kann höchsten 1,8 betragen, kann höchsten 1,7 betragen und kann beispielsweise im Bereich von 1,67 liegen.

Ringspiegel nach Anspruch 4 sind an die Symmetrie bei der Aufnahme eines rotationssymmetrisch emittierenden Strahlungsquellenbereichs gut angepasst. Die Ringspiegel können koaxial ineinander liegend angeordnet sein.

Ellipsoidförmige Spiegelflächen nach Anspruch 5 lassen sich mit vergleichsweise niedrigem Aufwand fertigen.

Eine sphärische Optik nach Anspruch 6 vergrößert den vom Kollektor erfassbaren Raumwinkelbereich um die Strahlungsquelle.

Die Vorteile eines Beleuchtungssystems nach Anspruch 7 entsprechen denen, die vorstehend im Zusammenhang mit dem erfindungsgemäßen Kollektor bereits erläutert wurden. Auf eine Zwischenabbildung der Strahlungsquelle im Strahlengang insbesondere vor dem Feldfacettenspiegel ist verzichtet, was das optische Design des Beleuchtungssystems vereinfacht.

Ein Einschnürungsbereich nach Anspruch 8 ermöglicht eine Trennung eines Strahlungsquellen-Moduls von einem nachgelagerten Beleuchtungsmodul des Beleuchtungssystems. Mitgeführte Fremdteilchen, die von Komponenten der Strahlungsquelle ausgesandt werden, können so einfacher unterdrückt werden. Der Einschnürungsbereich fällt nicht mit dem nachgelagerten Fokusbereich zusammen, der bei dem Beleuchtungssystem dem Einschnürungsbereich räumlich nachgeordnet ist.

Separate Kollektor-Spiegel nach Anspruch 9 vereinfachen die Herstellung einer Kollektor-Abbildungsoptik mit einschnürender und am Ort der Einschnürung nicht abbildender Wirkung. Die Kollektor-Spiegel können Spiegelflächen aufweisen, die als Freiformflächen gestaltet sind. Freiformflächen sind dabei Flächen, die mathematisch nicht durch eine rotationssymmetrische Funktion beschrieben werden können. Beispiele hierfür geben die WO 2012/013 241 A1 und die dort angegebenen Referenzen. Die Kollektor-Spiegel können so ausgeführt und angeordnet sein, dass ein maximaler Einfallswinkel des Beleuchtungslichts auf den Kollektor-Spiegeln kleiner ist als 45°.

Eine Randkonturgestaltung nach Anspruch 10 führt zu einer effizienten Führung des Beleuchtungslichts im Beleuchtungssystem.

Alternativ zu einer rechteckigen oder quadratischen Randkontur der Kollektor-Spiegel nach Anspruch 11 kann eine Randkontur der Kollektor-Spiegel auch hexagonal ausgeführt sein.

Die Vorteile einer Projektionsbelichtungsanlage nach Anspruch 12 sowie eines Herstellungsverfahrens nach Anspruch 13 entsprechen denen, die vorstehend unter Bezugnahme auf den erfindungsgemäßen Kollektor beziehungsweise unter Bezugnahme auf das erfindungsgemäße Beleuchtungssystem bereits erläutert wurden.

Ausführungsbeispiele der Erfindung werden nachfolgend anhand der Zeichnung näher erläutert. In dieser zeigen:
- Fig. 1: schematisch einen Meridionalschnitt durch eine Projektionsbelichtungsanlage für die EUV-Projektionslithographie mit einem EUV-Beleuchtungssystem mit einer EUV-Beleuchtungsoptik und einem EUV-Kollektor;
- Fig. 2: in einem Meridionalschnitt eine Ausführung des EUV-Kollektors mit einer Mehrzahl von separat zueinander angeordneten Kollektor-Abbildungsspiegeln, von denen einige als Ringspiegel ausgeführt sind;
- Fig. 3: perspektivisch eine weitere Ausführung des Kollektors, ebenfalls mit einer Mehrzahl von separat zueinander angeordneten Kollektor-Abbildungsspiegeln, von denen einige als Ringspiegel ausgeführt sind, und zusätzlich mit einer sphärischen Optik, ebenfalls ausgeführt als Ringspiegel;
- Fig. 4a und 4b: Bilder eines Strahlungsquellenbereiches, erzeugt mit dem Kollektor nach Fig. 3 einerseits mit Anteilen von Beleuchtungslicht mit kleinen Strahlwinkeln zu einer optischen Achse und andererseits mit Beleuchtungslicht-Anteilen mit großen Strahlwinkeln zur optischen Achse, dargestellt jeweils in einem Intensitätsdiagramm, aufgetragen über senkrecht zueinander stehende Ortskoordinaten;
- Fig. 5: ebenfalls in einem Meridionalschnitt stark schematisch einen Ausschnitt einer weiteren Ausführung eines Beleuchtungssystems mit einer Ausführung eines Kollektors, einem Feldfacettenspiegel, von dem in der Fig. 5 zwei Feldfacetten dargestellt sind, und einen Pupillenfacettenspiegel, von dem in der Fig. 5 zwei Pupillenfacetten dargestellt sind, wobei eine erste Abbildung des Strahlungsquellenbereichs der KollektorAbbildungsoptik im Lichtweg nach dem Strahlungsquellenbereich in einem nachgelagerten Fokusbereich stattfindet, der im Bereich des Pupillenfacettenspiegels liegt;

- Fig. 6: perspektivisch eine Ausführung des Beleuchtungssystems nach Fig. 5, wobei reflektierende Wirkungen der Feldfacetten und der Pupillenfacetten weggelassen sind und der Strahlengang des EUV-Beleuchtungslichts bis zum nachgelagerten Fokusbereich einer Mehrzahl von separat zueinander angeordneten Kollektor-Abbildungsspiegeln des Kollektors nach Fig. 5 dargestellt ist;
- Fig. 7a und 7b: Fernfeld-Intensitätsverteilungen für Ausführungen des Kollektors nach Fig. 5 und 6 einerseits mit einem Raster von 9x9 Kollektor-Abbildungsspiegeln und andererseits mit einem Raster von 19x19 Abbildungsspiegeln, jeweils in einer zu Fig. 5 ähnlichen Intensitätsdarstellung;
- Fig. 8: eine weitere Ausführung eines Beleuchtungssystems mit einem Kollektor, einem Feldfacettenspiegel und einem Pupillenfacettenspiegel, wobei eine reflektierende Wirkung des Feldfacettenspiegels zur besseren Veranschaulichung weggelassen ist;
- Fig. 9: perspektivisch beispielhafte Strahlengänge des Beleuchtungslichts im Beleuchtungssystem nach Fig. 8 zwischen Kollektor-Abbildungsspiegeln des Kollektors und Feldfacetten des Feldfacettenspiegels;
- Fig. 10: schematisch eine Ausführung einer Randkontur einer Spiegelfläche eines Kollektor-Spiegels einer Mehrzahl separat zueinander angeordneter Kollektor-Spiegel, wobei diese Randkontur zu einer Randkontur einer Feldfacetten-Gruppe aus zwei nebeneinander liegenden Feldfacetten einer Ausführung des Feldfacettenspiegels mit bogenförmigen Feldfacetten ähnlich ist;
- Fig. 11: gesehen in Richtung der optischen Achse zwischen dem Kollektor und dem Feldfacettenspiegel beispielhaft die Lichtwege des Beleuchtungslichts zwischen einzelnen KollektorAbbildungsspiegeln des Kollektors nach Fig. 9 und den Feldfacetten des Feldfacettenspiegels nach Fig. 9, wobei jeweils auch die Anordnung von dem Strahlungsquellenbereich nachgelagerten ersten Fokusbereichen, erzeugt durch die Kollektor-Abbildungsspiegel, dargestellt ist.

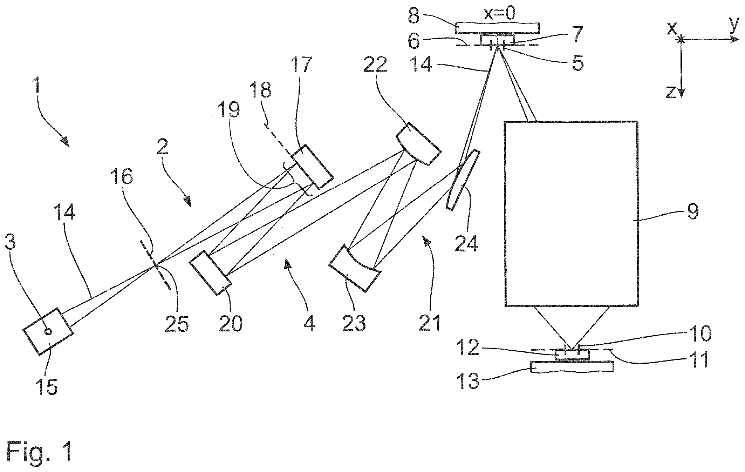

Fig. 1 zeigt schematisch in einem Meridionalschnitt eine EUV-Projektionsbelichtungsanlage 1 für die Mikrolithographie. Ein Beleuchtungssystem 2 der Projektionsbelichtungsanlage 1 hat neben einer Strahlungsquelle bzw. Lichtquelle 3 eine Beleuchtungsoptik 4 zur Belichtung eines Objektfeldes bzw. Beleuchtungsfeldes 5 in einer Objektebene 6. Belichtet wird hierbei ein im Objektfeld 5 angeordnetes Retikel 7, das von einem lediglich ausschnittsweise dargestellten Retikelhalter 8 gehalten ist. Eine Projektionsoptik 9 dient zur Abbildung des Objektfeldes 5 in ein Bildfeld 10 in einer Bildebene 11. Abgebildet wird eine Struktur auf dem Retikel 7 auf eine lichtempfindliche Schicht eines im Bereich des Bildfeldes 10 in der Bildebene 11 angeordneten Wafers 12, der von einem ebenfalls schematisch dargestellten Waferhalter 13 gehalten ist. Die Beleuchtungsoptik 4 und die Projektionsoptik 9 bilden gemeinsam ein optisches System der Projektionsbelichtungsanlage 1.

Bei der Strahlungsquelle 3 handelt es sich um eine EUV-Strahlungsquelle mit einer emittierten Nutzstrahlung im Bereich zwischen 5 nm und 30 nm. Es kann sich dabei um eine Plasmaquelle, insbesondere um eine LPP-Quelle (Plasmaerzeugung durch Laser, laser-produced plasma) handeln. Bei der EUV-Strahlenquelle kann es sich auch beispielsweise um eine DPP-Quelle (Plasmaerzeugung durch Gasentladung, gas discharge produced plasma) handeln. EUV-Strahlung 14, die von der Strahlungsquelle 3 ausgeht, wird von einem Kollektor 15 aufgenommen und gebündelt, der in der Fig. 1 stark schematisch als Block dargestellt ist. Der Kollektor 15 wird nachfolgend noch näher beschrieben. Die EUV-Strahlung 14 wird nachfolgend auch als Nutzemission, als Beleuchtungslicht oder als Abbildungslicht bezeichnet. Nach dem Kollektor 15 propagiert die EUV-Strahlung 14 bei der Ausführung nach Fig. 1 durch eine Zwischenfokusebene 16, bevor sie auf einen Feldfacettenspiegel 17 trifft. Eine solche Zwischenfokusebene 16 ist nicht zwingend. Anstelle eines einzigen Zwischenfokus, wie in der Fig. 1 schematisch dargestellt, können, wie nachfolgend noch erläutert wird, auch mehrere Zwischenfoki vorhanden sein oder auch astigmatische Foki in verschiedenen Ebenen oder auch gar kein Zwischenfokus. Der Feldfacettenspiegel 17 ist in einer Ebene 18 der Beleuchtungsoptik 4 angeordnet, die zur Objektebene 6 optisch konjugiert ist. In dieser Ebene 18 liegt ein Beleuchtungs-Fernfeld 19 der EUV-Strahlung 14 vor, welches durch die Überführung der Nutzemission 14 vom Kollektor 15 gebildet wird. Es kann eine lückenlose Ausleuchtung des gesamten Feldfacettenspiegels 17 erreicht werden.

Nach dem Feldfacettenspiegel 17 wird die EUV-Strahlung 14 von einem Pupillenfacettenspiegel 20 reflektiert. Der Pupillenfacettenspiegel 20 ist in einer Pupillenebene der Beleuchtungsoptik 4 angeordnet, die zu einer Pupillenebene der Projektionsoptik 9 optisch konjugiert ist. Mit Hilfe des Pupillenfacettenspiegels 20 abbildenden optischen Baugruppe in Form einer weiteren Übertragungsoptik 21 mit in der Reihenfolge des Strahlengangs bezeichneten Spiegeln 22, 23 und 24 werden Feldfacetten des Feldfacettenspiegels 17 in das Objektfeld 5 einander überlagernd abgebildet. Der letzte Spiegel 24 der Übertragungsoptik 21 ist ein Spiegel für streifenden Einfall ("Grazing Incidence-Spiegel"), also ein Spiegel mit einem Einfallswinkel der EUV-Strahlung, der deutlich größer ist als 45° und größer sein kann als 60°. Der Pupillenfacettenspiegel 20 und die Übertragungsoptik 21 bilden eine Folgeoptik zur Überführung des Beleuchtungslichts 14 in das Objektfeld 5. Auf die Übertragungsoptik 21 kann insbesondere dann verzichtet werden, wenn der Pupillenfacettenspiegel 20 in einer Eintrittspupille der Projektionsoptik 9 angeordnet ist. Der Pupillenfacettenspiegel 20 stellt dann die einzige Übertragungsoptik zur überlagernden Abbildung der Feldfacetten des Feldfacettenspiegels 17 in das Beleuchtungsfeld 5 dar.

Zur Erleichterung der Beschreibung von Lagebeziehungen ist in der Fig. 1 ein kartesisches xyz-Koordinatensystem als globales Koordinatensystem für die Beschreibung der Lageverhältnisse von Komponenten der Projektionsbelichtungsanlage 1 zwischen der Objektebene 6 und der Bildebene 11 eingezeichnet. Die x-Achse verläuft in der Fig. 1 senkrecht zur Zeichenebene und diese hinein. Die y-Achse verläuft in der Fig. 1 nach rechts. Die z-Achse verläuft in der Fig. 1 nach unten, also senkrecht zur Objektebene 6 und zur Bildebene 11. Ferner ist längs des Strahlengangs der Nutzemission 14 verschiedentlich ein lokales xyz-Koordinatensystem angegeben. Die z-Achse dieser lokalen Koordinatensysteme gibt jeweils die Strahlrichtung der Nutzemission 14 an. Die x-Achse der lokalen Koordinatensysteme verläuft regelmäßig parallel zur x-Achse des globalen Koordinatensystems. Die y-Achse des lokalen Koordinatensystems ist je nach der Orientierung des lokalen Koordinatensystems gegenüber der y-Achse des globalen Koordinatensystems verkippt.

Der Retikelhalter 8 und der Waferhalter 13 sind beide gesteuert so verlagerbar, dass bei der Projektionsbelichtung das Retikel 7 und der Wafer 12 in einer Verlagerungsrichtung, nämlich in der y-Richtung des globalen xyz-Koordinatensystems, einerseits durch das Objektfeld 5 und andererseits durch das Bildfeld 10 gescannt werden. Die Verlagerungsrichtung y wird nachfolgend auch als Scanrichtung bezeichnet.

Der EUV-Kollektor 15 dient zur Überführung der Nutzemission 14 der EUV-Strahlungsquelle 3 in das EUV-Fernfeld 19. Im EUV-Fernfeld 19 ist der Feldfacettenspiegel 17 als weitere EUV-Spiegelkomponente angeordnet, die die Nutzemission 14 in das Beleuchtungsfeld 5 überführt.

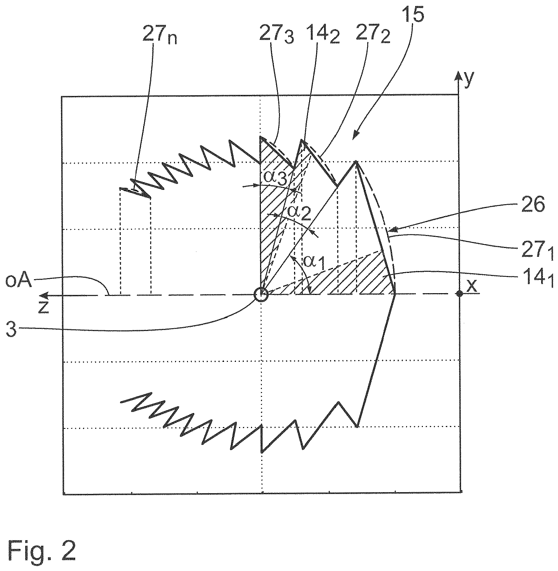

Fig. 2 zeigt in einem Meridionalschnitt eine Ausführung des Kollektors 15. Komponenten und Funktionen, die vorstehend unter Bezugnahme auf die Fig. 1 bereits erläutert wurden, tragen die gleichen Bezugsziffern und werden nicht nochmals im Einzelnen diskutiert. In der Fig. 2 ist ein lokales kartesisches xyz-Koordinatensystem eingezeichnet. Die x-Achse des Koordinatensystems nach Fig. 2 verläuft parallel zur x-Achse des globalen Koordinatensystems nach Fig. 1 und senkrecht zur Zeichenebene der Fig. 2 aus dieser heraus. Die y-Achse verläuft in der Fig. 2 nach oben. Die z-Achse verläuft in der Fig. 2 nach links und verläuft parallel zu einer Haupt-Strahlrichtung eines Strahlengangs des Beleuchtungslichts 14 nach dem Kollektor 15. Die z-Achse verläuft auf einer Verbindungslinie zwischen der Lichtquelle 3, beispielsweise einem strahlenden Plasmavolumen, das auch als Strahlungsquellenbereich bezeichnet ist, und einem Zwischenfokus 25 (vgl. Fig. 1). Diese Verbindungslinie zwischen dem Strahlungsquellenbereich 3 und dem nachgelagerten Fokusbereich 25 stellt gleichzeitig eine optische Achse oA des Kollektors 15 dar. Der Zwischenfokus 25 stellt einen nachgelagerten Fokusbereich dar. In diesen nachgelagerten Fokusbereich 25 bildet der Kollektor 15 den Strahlungsquellenbereich 3 mit Hilfe einer Kollektor-Abbildungsoptik 26 ab.

Der Kollektor 15 ist um die z-Achse rotationssymmetrisch ausgeführt.

Die Kollektor-Abbildungsoptik 26 hat eine Mehrzahl von separat zueinander angeordneten Kollektor-Abbildungsspiegeln 27ₙ, von denen in der Fig. 2 im Halbraum positiver y-Werte gestrichelt die drei innersten Kollektor-Abbildungsspiegel 27₁, 27₂ und 27₃ im Meridionalschnitt dargestellt sind. Abgesehen vom innersten Kollektor-Abbildungsspiegel 27₁ sind alle anderen Kollektor-Abbildungsspiegel 27ₙ als Ringspiegel ausgeführt. Die Ringspiegel 27ₙ sind koaxial ineinander liegend angeordnet. Der der z-Achse nächst benachbarte, innerste Kollektor-Abbildungsspiegel 27₁ ist als Ellipsoidschale ausgeführt. Diese kann dort, wo sie von der z-Achse durchstoßen wird, eine Durchtrittsöffnung für einen Laserstrahl zum Zünden des Plasmas im Strahlungsquellenbereich 3 aufweisen, was in der Fig. 2 nicht dargestellt ist. Die weiteren Kollektor-Abbildungsspiegel 27₂ bis 27ₙ haben jeweils wiederum ellipsoidförmige Spiegelflächen, die im Halbraum positiver y-Werte in der Fig. 2 für die Kollektor-Abbildungsspiegel 27₂, 27₃ und 27ₙ gestrichelt angedeutet sind.

Die Unterteilung in die Kollektor-Abbildungsspiegel 27ₙ ist in der Fig. 2 durch eine gezackte, durchgezogene Linie angedeutet, deren Linienabschnitte jeweils gerade verlaufen und die mit den gestrichelten Spiegelflächen nicht zusammenfällt.

Der Kollektor-Abbildungsspiegel 27₁ nimmt EUV-Beleuchtungslicht 14 auf, das vom Strahlungsquellenbereich 3 mit Strahlwinkeln α₁ emittiert wird, die kleiner sind als 55°. Der Kollektor-Abbildungsspiegel 27₂, also die zweite Ellipsoidschale des Kollektors 15 und gleichzeitig der erste Ringspiegel, nimmt das vom Strahlungsquellenbereich 3 emittierte Beleuchtungslicht 14 in einem Strahlwinkelbereich α₂ zwischen 55° und etwa 73° auf. Der nächste Kollektor-Abbildungsspiegel 27₃ nimmt das vom Strahlungsquellenbereich 3 emittierte Beleuchtungslicht 14 in einem Strahlwinkelbereich α₃ zwischen etwa 73° und 90° auf. Die folgenden Kollektor-Abbildungsspiegel 27₄ bis 27ₙ nehmen das vom Strahlungsquellenbereich 3 emittierte Beleuchtungslicht 14 mit jeweils zugeordneten Strahlwinkelbereichen αₙ auf, die den Strahlwinkelbereich zwischen 90° und etwa 145° abdecken. Die Kollektor-Abbildungsspiegel 27₁ bis 27ₙ sind also so ausgeführt, dass sie jeweils Anteile des EUV-Beleuchtungslichts 14 vom Strahlungsquellenbereich 3 erfassen, die in einem Winkelbereich von Strahlwinkeln αₙ zur optischen Achse oA zwischen dem Strahlungsquellenbereich 3 und dem nachgelagerten Fokusbereich 25 emittiert sind.

Der innerste Kollektor-Abbildungsspiegel 27₁ bildet insbesondere EUV-Beleuchtungslicht 14 ab, das vom Strahlungsquellenbereich 3 mit Strahlwinkeln < 20° zur optischen Achse zwischen dem Strahlungsquellenbereich 3 und dem nachgelagerten Fokusbereich 25 emittiert wird.

Diese Abbildung durch den innersten Kollektor-Abbildungsspiegel 27₁ erfolgt mit einem ersten Abbildungsmaßstab β₁.

Beim Abbildungsmaßstab β handelt es sich um einen Flächenabbildungsmaßstab. Der Abbildungsmaßstab β gibt also das Verhältnis an, um das eine abzubildende Fläche verkleinert bzw. vergrößert wird.

Der Kollektor-Abbildungsspiegel 27₂ bildet das auf diesen auftreffende Beleuchtungslicht 14 im Strahlwinkelbereich α₂ mit einem zweiten Abbildungsmaßstab β₁ ab. Zu dem Beleuchtungslicht, das vom zweiten Kollektor-Abbildungsspiegel 27₂ abgebildet wird, gehört Beleuchtungslicht 14, das vom Strahlungsquellenbereich 3 mit Strahlwinkeln >70°, nämlich im Strahlwinkelbereich zwischen 70° und 73°, zur optischen Achse oA emittiert wird.

Diese Anteile des Beleuchtungslichts 14 einerseits emittiert mit Strahlwinkeln < 20° und andererseits emittiert mit Strahlwinkeln > 70°, die von dem Kollektor-Abbildungsspiegel 27₁ einerseits und 27₂ andererseits abgebildet werden, sind in der Fig. 2 schraffiert bei 14₁ und 14₂ angedeutet.

Die beiden Abbildungsmaßstäbe β₁,₂₀ und β₂,₇₀ einerseits für das EUV-Beleuchtungslicht, das mit Strahlwinkeln < 20° vom innersten Kollektor-Abbildungsspiegel 27₁ in den nachgelagerten Fokusbereich 25 abgebildet wird, und andererseits für das Beleuchtungslicht 14, das mit Strahlwinkeln > 70° vom zweiten Kollektor-Abbildungsspiegel 27₂ abgebildet wird, also die Abbildungsmaßstäbe β₁ und β₂ für diese ausgewählten Strahlwinkelbereiche, unterscheiden sich um nicht mehr als einen Faktor 2,5.

Ein Unterschied zwischen den Abbildungsmaßstäben β_{1,20} und β_{2,70} kann je nach Ausführung des Kollektors 15 auch nicht größer sein als 2,25, kann nicht größer sein als 2,0, kann nicht größer sein als 1,9, kann nicht größer sein als 1,8, kann nicht größer sein als 1,7, kann nicht größer sein als 1,6 und kann auch nicht größer sein als 1,5. Je nach diesen Maximalunterschieden zwischen den Abbildungsmaßstäben β_{1,20} und β_{2,70} ergibt sich ein entsprechend geringer Unterschied der Größe des Zwischenfokusbereichs 25, der einerseits durch Abbildung des Strahlungsquellenbereichs 3 über den Kollektor-Abbildungsspiegel 27₁ und andererseits durch Abbildung über den Kollektor-Abbildungsspiegel 27₂ resultiert. Die durch die an die Strahlwinkel α angepassten Abbildungsmaßstäbe reduzierte Abbildungsmaßstab-Variation für die verschiedenen Strahlwinkel resultiert damit in einer entsprechend reduzierten Variation der Größen der verschiedenen Strahlungsquellenbilder im Zwischenfokusbereich 25 (vgl. Fig. 1) für die Beleuchtungslicht-Anteile, die mit unterschiedlichen Strahlwinkeln α₁ aus dem Strahlungsquellenbereich 3 emittiert werden. Insgesamt resultiert ein Zwischenfokusbereich 25 mit geringer Größenvariation.

Entsprechend ist auch der Abbildungsmaßstab β₃ für den dritten Kollektor-Abbildungsspiegel 27₃ an die Strahlwinkel α₃ des Beleuchtungslichts 14 angepasst, sodass sich im Vergleich zu den Abbildungsmaßstäben β_{1,20} und β₂,₇₀ wiederum nur ein geringer Abbildungsmaßstab-Unterschied ergibt.

Der Abbildungsmaßstab βₙ jedes Kollektor-Abbildungsspiegels 27ₙ variiert zwischen einem minimalen Abbildungsmaßstab β_{n,min} und einem maximalen Abbildungsmaßstab β_{n,max}, abhängig vom jeweiligen Strahlwinkel αₙ des Beleuchtungslichts 14 auf dem Kollektor-Abbildungsspiegel 27ₙ. Für das Verhältnis β_{n,max}/β_{n,min} zwischen diesen Abbildungsmaßstäben auf ein und demselben Kollektor-Abbildungsspiegel 27ₙ gilt: β_{n,max}/β_{n,min} ≤ 2. Je nach Ausführung kann dieses Verhältnis auch ≤ 1,9 sein, kann ≤ 1,8 sein, kann ≤ 1,7 sein und kann beispielsweise 1,67 betragen.

Bei der Ausführung nach Fig. 2 liegt eine normierte Maßstabsvariation βₙ/β₀ für jeden Kollektor-Abbildungsspiegel 27ₙ im Invervall [0.75, 1.25]. β₀ ist dabei ein für den Kollektor 15 insgesamt vorgegebener Norm-Abbildungsmaßstab.

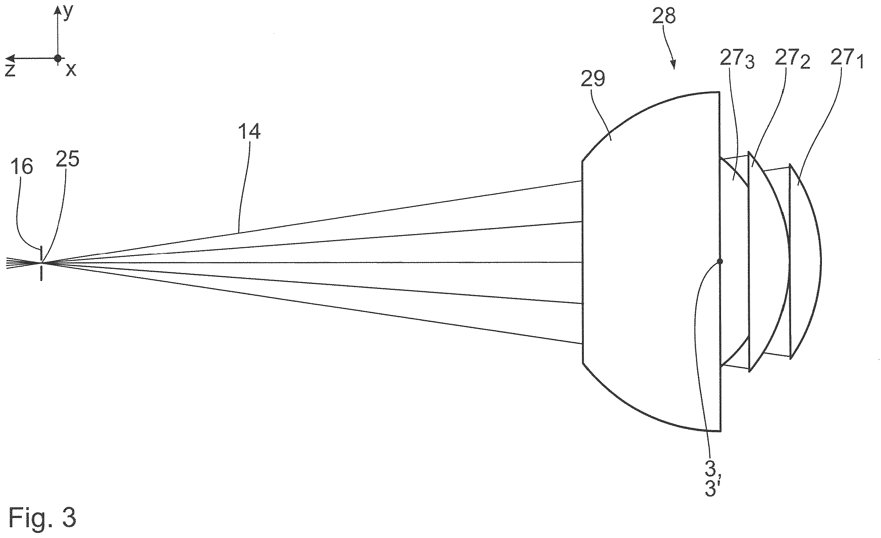

Fig. 3 zeigt eine weitere Ausführung eines Kollektors 28, der anstelle des Kollektors 15 nach den Fig. 1 und 2 zum Einsatz kommen kann. Komponenten und Funktionen, die denjenigen entsprechen, die vorstehend unter Bezugnahme auf die Fig. 1 und 2 bereits erläutert wurden, tragen die gleichen Bezugsziffern und werden nicht nochmals im Einzelnen diskutiert.

Der Kollektor 28 hat drei innere Kollektor-Abbildungsspiegel 27₁, 27₂ und 27₃, die entsprechend dem gestaltet sind, was vorstehend im Zusammenhang mit der Fig. 2 bereits erläutert wurde. Über die drei Kollektor-Abbildungsspiegel 27₁ bis 27₃ wird ein Strahlwinkelbereich α bis zu einem maximalen Strahlwinkel α_{3,max} von 90° erfasst, also der gleiche Strahlwinkelbereich wie durch die Ringspiegel 27₁ bis 27₃ des Kollektors 15 nach Fig. 2.

Anstelle weiterer Ringspiegel 27ₙ hat der Kollektor 28 eine sphärische Optik 29, die den Strahlungsquellenbereich 3 im Wesentlichen in sich selbst in einen Strahlungsquellen-Bildbereich 3' abbildet, der im Bereich des Strahlungsquellenbereichs 3 liegt, also mit diesem entweder zusammenfällt oder diesem nahe benachbart ist. Dies sphärische Optik 29 ist beim Kollektor 28 ebenfalls als Ringspiegel ausgeführt und deckt einen Bereich von Strahlwinkeln a, mit denen das Beleuchtungslicht vom Strahlungsquellenbereich 3 emittiert wird, zwischen 90° und etwa 140° ab. An der sphärischen Optik 29 wird das Beleuchtungslicht 14 im Wesentlichen in sich selbst zurückreflektiert und wird anschließend vom Strahlungsquellen-Bildbereich 3' durch die Kollektor-Abbildungsspiegel 27₁ bis 27₃ in den Zwischenfokusbereich 25 abgebildet, wie vorstehend im Zusammenhang mit der Fig. 2 bereits erläutert.

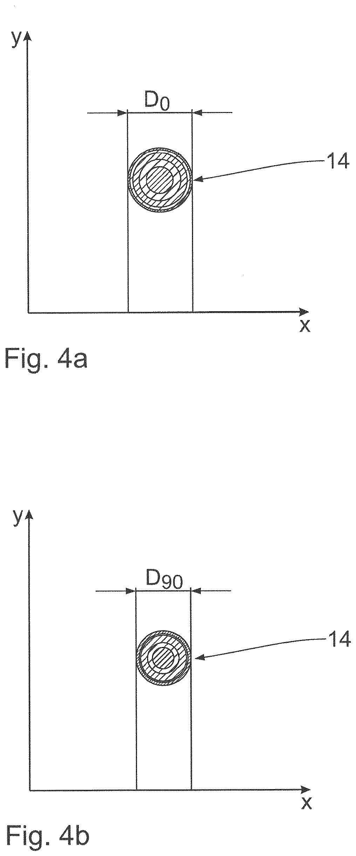

Fig. 4 zeigt beispielhaft einen xy-Querschnitt eines Anteils eines Bündels des Beleuchtungslichts 14 in der Zwischenfokusebene 16, also einen Querschnitt durch den jeweiligen Anteil des Zwischenfokusbereichs 25.

Fig. 4a zeigt hierbei den Anteil des Bündels des Beleuchtungslichts 14, der mit kleinen Strahlwinkeln, beispielsweise mit Strahlwinkeln α ≤ 10°, vom Kollektor-Abbildungsspiegel 27₁ reflektiert wird. Ein Durchmesser des zugehörigen Anteils des Beleuchtungslichts 14 im Zwischenfokusbereich 25 beträgt 4,0 in willkürlichen Einheiten. Dieser Durchmesser wird auch als D₀ bezeichnet.

Fig. 4b zeigt den entsprechenden Durchmesser für den Anteil des Bündels des Beleuchtungslichts 14, der mit Strahlwinkeln α im Bereich von 90° vom Kollektor-Abbildungsspiegel 27₃ in den Zwischenfokusbereich 25 abgebildet wird. In den gleichen willkürlichen Einheiten beträgt der Durchmesser für diesen Beleuchtungslichtanteil 3,2. Dieser Durchmesser wird auch als D₉₀ bezeichnet.

Ein Durchmesserverhältnis D₀/D₉₀ zwischen diesen Anteilen des Beleuchtungslichts 14 beträgt 4,0/3,2 = 1,25. Entsprechend gilt für das Flächenverhältnis der Zwischenfokusbereiche einerseits für die kleinen Strahlwinkel nach Fig. 4a und andererseits für die großen Strahlwinkel nach Fig. 4b A₀/A₉₀ = 1,56.

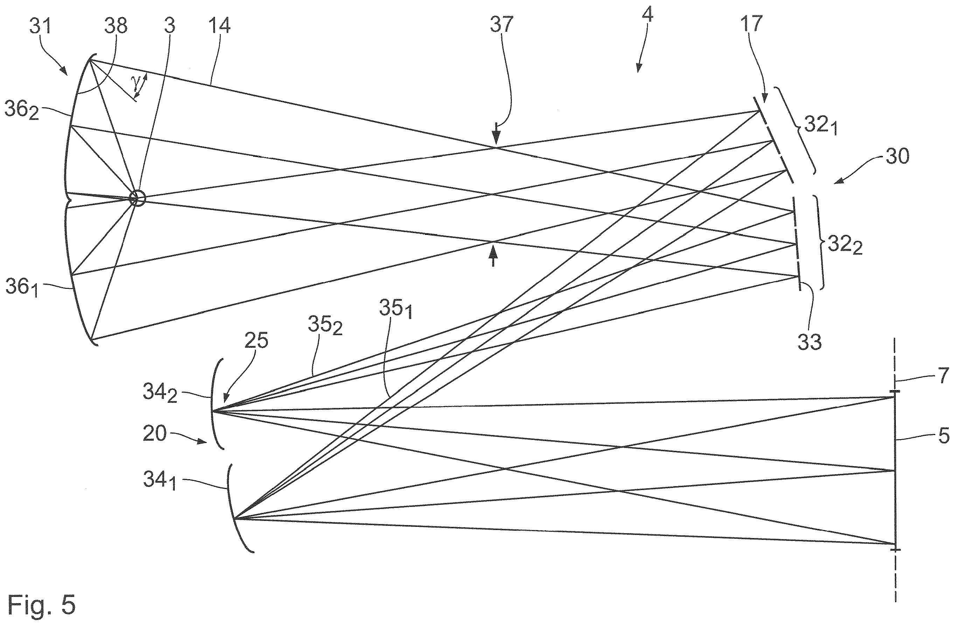

Fig. 5 zeigt eine weitere Ausführung eines Beleuchtungssystems 30, welches anstelle des Beleuchtungssystems 2 bei der Projektionsbelichtungsanlage 1 nach Fig. 1 zum Einsatz kommen. Komponenten und Funktionen, die denjenigen entsprechen, die vorstehend unter Bezugnahme auf die Fig. 1 bis 4 bereits erläutert wurden, tragen die gleichen Bezugsziffern und werden nicht nochmals im Einzelnen diskutiert.

Das Beleuchtungssystem 30 hat einen Kollektor 31.

In der schematischen Darstellung nach Fig. 5 sind zwei Feldfacetten 32₁, 32₂ des Feldfacettenspiegels 17 gezeigt, die ihrerseits aus mehreren Einzelspiegeln 33 aufgebaut sind, von denen in der Fig. 5 jeweils drei Einzelspiegel 33 für jede Feldfacette 32 gezeigt sind. In der Praxis kann die Anzahl der Einzelspiegel 33 pro Feldfacette 32 wesentlich höher sein.

Die Anzahl der Feldfacetten 32 ist in der Praxis wesentlich höher. Es können beispielsweise einige Hundert Feldfacetten 32 beim Feldfacettenspiegel 17 vorhanden sein.

In der Fig. 5 sind weiterhin schematisch zwei Pupillenfacetten 34₁ und 34₂ des Pupillenfacettenspiegels 20 dargestellt, die den Feldfacetten 32₁ und 32₂ über Ausleuchtungskanäle 35₁ und 35₂ zugeordnet sind.

Ein nachgelagerter Fokusbereich 25, der funktional dem Fokusbereich 25 nach Fig. 1 entspricht, stellt die erste Abbildung des Strahlungsquellenbereichs 3 von Kollektor-Abbildungsspiegeln 36₁, 36₂ des Kollektors 31 im Strahlengang des Beleuchtungslichts 14 nach dem Strahlungsquellenbereich 3 dar. Dieser nachgelagerte Fokusbereich 25 liegt beim Beleuchtungssystem 30 im Bereich des Pupillenfacettenspiegels 20.

Die Pupillenfacetten 34 gehören zu einer Pupillenfacetten-Übertragungsoptik, die die Feldfacetten 32 einander überlagernd in das Objektfeld 5 abbilden, wie in der Fig. 5 schematisch dargestellt ist.

Zwischen dem Kollektor 31 und einer ersten Komponente der Beleuchtungsoptik 4 des Beleuchtungssystems 30, also dem Feldfacettenspiegel 17, liegt ein Einschnürungsbereich 37. Im Einschnürungsbereich 37 ist ein Querschnitt eines gesamten Bündels des EUV-Beleuchtungslichts 14 im Bereich zum Querschnitt auf dem Feldfacettenspiegel 17 um mindestens einen Faktor 2 verringert, was in der schematischen Darstellung der Fig. 5, in der lediglich zwei Feldfacetten 32 dargestellt sind, nicht maßstabsgetreu wiedergegeben ist.

Der Einschnürungsbereich 37 stellt keinen Fokusbereich der Kollektor-Abbildungsoptik des Kollektors 31 dar. Der Fokusbereich 25 ist nachfolgend im Strahlengang des Beleuchtungslichts 14, nämlich im Bereich des Pupillenfacettenspiegels 20, angeordnet. Zwischen dem Einschnürungsbereich 37 und dem Fokusbereich 25 ist im Strahlengang des Beleuchtungslichts 14 der Feldfacettenspiegel 17 angeordnet.

Die Kollektor-Abbildungsspiegel 36ₙ des Kollektors 31 sind als Freiformflächen ausgebildet. Spiegelflächen 38 der Kollektor-Abbildungsspiegel 36ₙ sind so ausgeführt, dass ein maximaler Einfallswinkel γₘₐₓ des Beleuchtungslichts 14 auf den Kollektor-Abbildungsspiegeln 36ₙ kleiner ist als 45°. Eine Randkontur der Kollektor-Abbildungsspiegel 36ₙ ist zu einer Randkontur der Feldfacetten 32ₙ ähnlich ausgeführt.

Die Kollektor-Abbildungsspiegel 36ₙ haben eine rechteckige Randkontur. Alternativ ist auch, insbesondere dann, wenn bogenförmige Feldfacetten 32ₙ zum Einsatz kommen, eine gebogene und beispielsweise teilringförmige Randkontur der Kollektor-Abbildungsspiegel 36ₙ möglich.

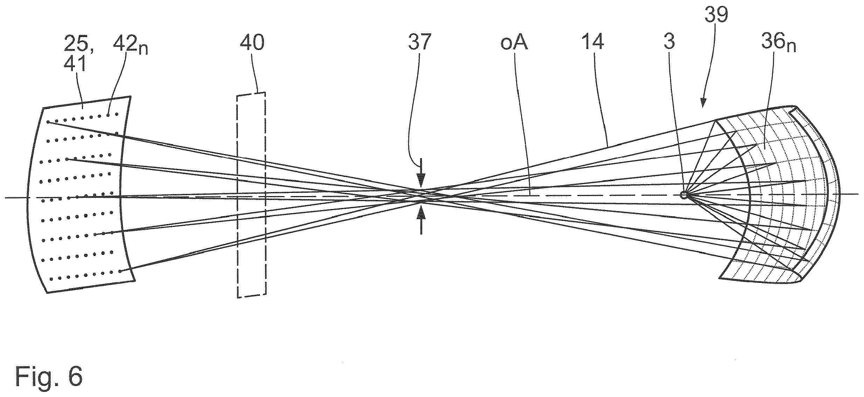

Fig. 6 zeigt in einer schematischen Darstellung eine weitere Ausführung eines Kollektors 39, der insbesondere anstelle des Kollektors 31 zum Einsatz kommen kann. Komponenten und Funktionen, die vorstehend im Zusammenhang mit den Fig. 1 bis 5 und insbesondere im Zusammenhang mit der Fig. 5 bereits erläutert wurden, tragen die gleichen Bezugsziffern und werden nicht nochmals im Einzelnen diskutiert.

Der Kollektor 39 hat insgesamt 81 Kollektor-Abbildungsspiegel 36ₙ, die rasterartig zeilen- und spaltenweise nach Art einer 9x9-Matrix kachelförmig dicht gepackt angeordnet sind. Dargestellt ist in der Fig. 6 im Strahlengang nach dem Einschnürungsbereich 37 eine Anordnungsebene 40 für einen Feldfacettenspiegel nach Art des Feldfacettenspiegels 17. Der Feldfacettenspiegel selbst und auch dessen reflektierende Wirkung auf das Beleuchtungslicht 14 sind in der Fig. 6 nicht dargestellt. Gezeigt ist in der Fig. 6 im weiteren Verlauf des beispielhaft für einige Kollektor-Abbildungsspiegel 36ₙ dargestellten Strahlengangs des Beleuchtungslichts 14 nach der Anordnungsebene 40 die abbildende Wirkung der Kollektor-Abbildungsspiegel 36ₙ, sodass in einer perspektivisch in der Fig. 6 dargestellten weiteren Anordnungsebene 41, in der ein Pupillenfacettenspiegel nach Art des Pupillenfacettenspiegels 20 angeordnet werden, ein 9x9-Raster von Strahlungsquellenbildern 42ₙ entsteht, die als erste Bilder des Strahlungsquellenbereichs 3 im Strahlengang bzw. Lichtweg des Beleuchtungslichts 14 nach dem Strahlungsquellenbereich 3 von den Kollektor-Abbildungsspiegeln 36ₙ erzeugt werden. Am Ort jedes Strahlungsquellenbildes 42ₙ ist eine Pupillenfacette des Pupillenfacettenspiegels 20 angeordnet. Die Anordnungsebene 41 der Strahlungsquellenbilder 42ₙ stellt den Zwischenfokusbereich 25 des Kollektors 39 dar. Fig. 6 zeigt deutlich, dass dieser erste, dem Strahlungsquellenbereich 3 nachgelagerte Zwischenfokusbereich 41 räumlich getrennt ist vom Einschnürungsbereich 37.

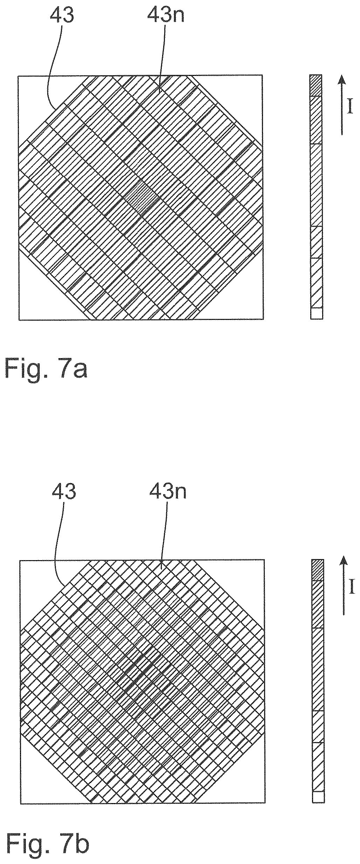

Fig. 7 zeigt Fernfeld-Varianten des Beleuchtungslichts 14, die einerseits durch den Kollektor 39 und andererseits durch einen entsprechend aufgebauten, alternativen Kollektor mit nach Art einer 19x19-Matrix angeordneten Kollektor-Abbildungsspiegeln erzeugt werden. Schraffiert sind verschiedene Intensitätswerte I entsprechend der jeweils rechts angedeuteten Skala angegeben.

Die Fernfelder nach den Fig. 7a, 7b liegen dort vor, wo die über die einzelnen Kollektor-Abbildungsspiegel 36ₙ geführten Teilstrahlen des Beleuchtungslichts 14 nach dem Einschnürungsbereich 37 gerade wieder vollständig auseinander gelaufen sind. In diesem Fernfeld sieht kein Fernfeld-Punkt Licht von mehr als einem Kollektor-Abbildungsspiegel 36ₙ. Eine Anordnung eines Feldfacettenspiegels in der Anordnungsebene 40 führt also dazu, dass keine Feldfacette mit Beleuchtungslicht 14 beaufschlagt ist, dass von mehr als einem Kollektor-Abbildungsspiegel 36ₙ reflektiert ist.

Aufgrund einer Kippausrichtung der Kollektor-Abbildungsspiegel 36ₙ zur Erzeugung des Einschnürungsbereichs 37 ergibt sich im Fernfeld eine kachelartig versetzte abschnittsweise Zusammensetzung des gesamten Fernfeldes 43. Beim 9x9-Fernfeld 43 nach Fig. 7a sind Intensitätsstufen an den den einzelnen Kollektor-Abbildungsspiegeln 36ₙ zugeordneten, benachbarten Fernfeld-Abschnitten 43ₙ größer als beim 19x19-Fernfeld nach Fig. 7b.

Je größer bei gegebener Kollektorgröße die Anzahl der Kollektor-Abbildungsspiegel 36ₙ ist, die matrixartig nach Art des Kollektors 39 angeordnet werden, desto kleiner ist ein relativ zur Größe des Kollektors sich ergebender Querschnitt des Einschnürungsbereichs 37 möglich. Ein Querschnitt des Einschnürungsbereichs 37 kann beispielsweise mit einer absoluten Größe von 20mm x 20mm oder auch von 40mm x 40mm erreicht werden.

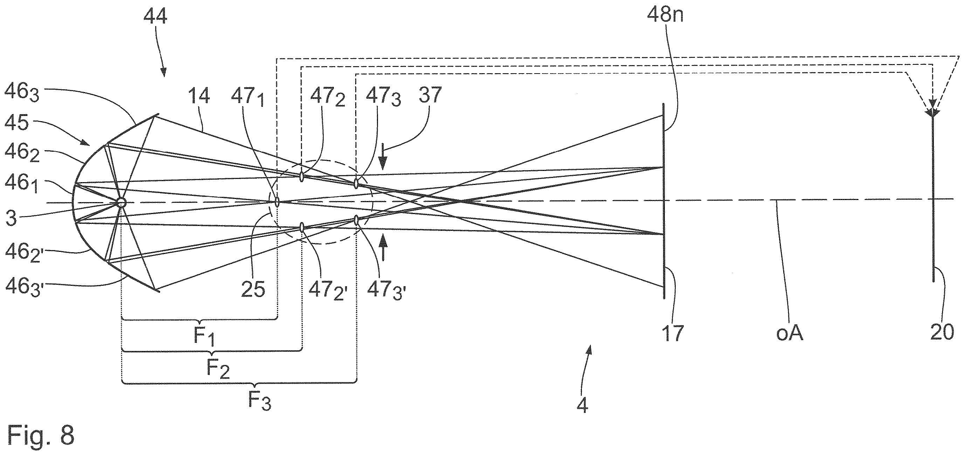

Fig. 8 zeigt eine weitere Ausführung eines Beleuchtungssystems 44, das wiederum anstelle des Beleuchtungssystems 2 bei der Projektionsbelichtungsanlage 1 zum Einsatz kommen kann. Komponenten und Funktionen, die denjenigen entsprechen, die vorstehend unter Bezugnahme auf die Fig. 1 bis 7 bereits erläutert wurden, tragen die gleichen Bezugsziffern und werden nicht nochmals im Einzelnen diskutiert.

Ein Kollektor 45 des Beleuchtungssystems 44 hat Kollektor-Abbildungsspiegel 46ₙ, von denen in der Fig. 8 insgesamt fünf Kollektor-Abbildungsspiegel, nämlich ein innerster Kollektor-Abbildungsspiegel 46₁, zwei diesem benachbarte mittlere Kollektor-Abbildungsspiegel 46₂, 46_{2'} und wiederum diesen benachbarte, äußere Kollektor-Abbildungsspiegel 46₃, 46_{3'} dargestellt sind.

Der innerste Kollektor-Abbildungsspiegel 46₁ bildet Anteile des Beleuchtungslichts 14 ab, die mit Strahlwinkeln zur optischen Achse oA vom Strahlungsquellenbereich 3 emittiert werden, die kleiner sind als 20°. Die Strahlwinkel, die wiederum von den äußersten Kollektor-Abbildungsspiegeln 46₃, 46_{3'} abgebildet werden, sind größer als 70°. Die zwischenliegenden mittleren Kollektor-Abbildungsspiegel 46₂, 46₂, bilden zwischenliegende Strahlwinkel des Beleuchtungslichts 14 ab.

Eine abbildende Wirkung des innersten Kollektor-Abbildungsspiegels 46₁ ist so, dass ein Zwischenfokus 47₁, der als Abbildung des Strahlungsquellenbereichs 3 vom Kollektor-Abbildungsspiegel 46₁ generiert wird, in einem Abstand F₁ zum Strahlungsquellenbereich 3 angeordnet ist. Der Zwischenfokus 47₁ liegt auf der optischen Achse oA.

Zwischenfoci 47₂, 47_{2'}, die von den mittleren Kollektor-Abbildungsspiegeln 46₂, 46_{2'} erzeugt werden, haben einen Abstand F₂ zum Strahlungsquellenbereich 3, für den gilt, F₂ > F₁. Die Zwischenfoci 47₂, 47_{2'} sind von der optischen Achse oA beabstandet.

Zwischenfoci 47₃, 47_{3'}, die von den äußeren Kollektor-Abbildungsspiegeln 46₃, 46_{3'} erzeugt werden, haben einen Abstand F₃ zum Strahlungsquellenbereich 3, für den gilt: F₃ > F₂. Die Zwischenfoci 47₃, 47_{3'} sind wiederum von der optischen Achse oA beabstandet.

Die Zwischenfoci 47₁, 47₂, 47_{2'}, 47₃, 47_{3'} sind jeweils räumlich voneinander getrennt.

Ein Einschnürungsbereich 37 des gesamten Bündels des Beleuchtungslichts 14 liegt zwischen dem Kollektor 45 und dem Feldfacettenspiegel 17, der in der Fig. 8 wiederum schematisch ohne reflektierende Wirkung dargestellt ist.

Der Einschnürungsbereich 37 ist zumindest von einigen der Zwischenfoci 47, nämlich von den Zwischenfoci 47₁, 47₂ und 47_{2'}, räumlich beabstandet. Der Einschnürungsbereich 37 fällt also auch bei dieser Ausführung nicht im dem Fokusbereich 25 zusammen.

Aufgrund der verschiedenen Fokalabstände F_{1,} F₂, F₃ werden unterschiedliche Abbildungsmaßstäbe β_{K} der Kollektor-Abbildungsspiegel 46, die aufgrund der unterschiedlichen von diesen abgebildeten Strahlwinkeln des Beleuchtungslichts 14 resultieren, so ausgeglichen, dass eine Größenvariation der Zwischenfoci 47 reduziert ist.

Die Zwischenfoci 47 werden von den diesen zugeordneten Feldfacetten 48ₙ mit unterschiedlichen Facetten-Abbildungsmaßstäben β_{F} so auf die Pupillenfacetten des Pupillenfacettenspiegels 20 abgebildet, dass Bilder der Zwischenfoci 47 auf den Pupillenfacetten im Wesentlichen gleich groß sind und sich im Querschnitt beispielsweise um weniger 30 %, um weniger als 20 %, um weniger als 15 %, um weniger als 10 % oder sogar um weniger als 5 % unterscheiden.

Ein erster Fokusbereich, nämlich der Zwischenfokus 47₁ wird beispielsweise mit einem ersten Facetten-Abbildungsmaßstab β_{F1} abgebildet. Ein zweiter Fokusbereich, beispielsweise die Zwischenfoci 47₂, 47_{2'}, werden mit einem zweiten Facetten-Abbildungsmaßstab β_{F2} abgebildet. Der gesamte Fokusbereich 25 ist bei der Ausführung nach Fig. 8 durch die verschiedenen räumlich getrennt liegenden Zwischenfoci 47ₙ gebildet.

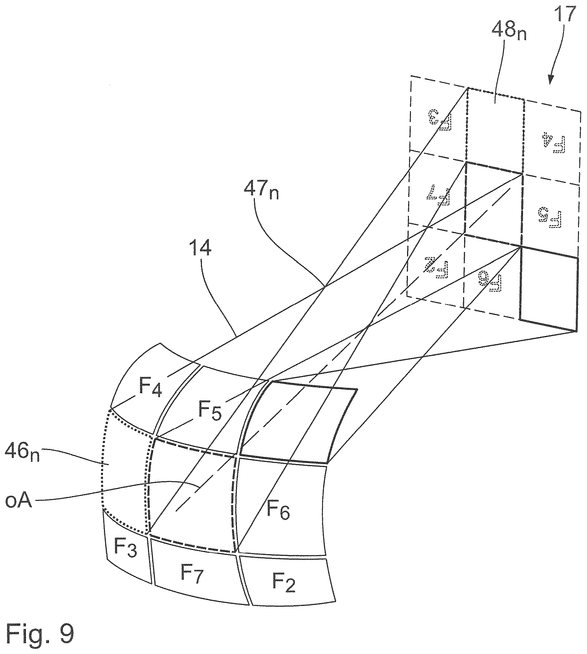

Fig. 9 zeigt eine Zuordnung zwischen den Kollektor-Abbildungsspiegeln 46ₙ und den Feldfacetten 48ₙ. Der Index n der Zuordnung Fₙ ist für die Kollektor-Abbildungsspiegel 46 und die Feldfacetten 48 in der Fig. 9 jeweils als große Zahl dargestellt. Aufgrund der invertierenden Wirkung über die Zwischenfoci 47ₙ sind diese Indizes auf dem Feldfacettenspiegel 17 auf den Kopf gestellt abgebildet.

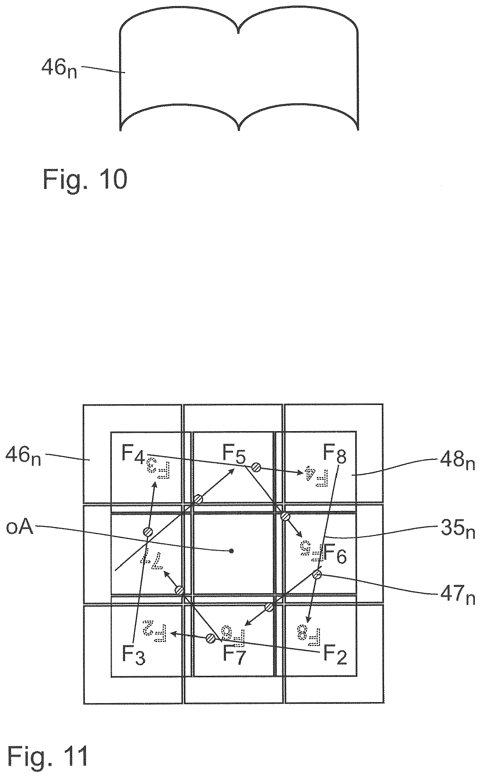

Die Kollektor-Abbildungsspiegel 46ₙ können quadratisch, rechteckig, hexagonal oder, wie in der Fig. 10 dargestellt, auch bogenförmig hinsichtlich ihrer Randkontur geformt sein. Die Kollektor-Abbildungsspiegel 46ₙ können dabei als Einzelbögen geformt sein, was nicht näher dargestellt ist, oder zur Beaufschlagung zweier benachbarter bogenförmiger Feldfacetten 48ₙ, auch als Doppelbögen, wie in der Fig 10 dargestellt. Mit einem Kollektor-Abbildungsspiegel 46ₙ kann mehr als eine Feldfacette 48ₙ mit dem Beleuchtungslicht 14 beaufschlagt werden, beispielsweise eine Gruppe von Feldfacetten 48ₙ. Sofern die Feldfacetten 48ₙ zeilen- und spaltenweise angeordnet sind, kann die Gruppe gleichzeitig von einem Kollektor-Abbildungsspiegel 46ₙ mit dem Beleuchtungslicht 14 beaufschlagter Feldfacetten 48ₙ in mehreren Spalten und/oder in mehreren Zeilen dieser Feldfacettenanordnung liegen. Mit einer Randkontur eines Kollektor-Abbildungsspiegels 46ₙ nach Fig. 10 können beispielsweise zwei nebeneinander liegende Spalten gebogener Feldfacetten 48ₙ ausgeleuchtet werden.

Die Anzahl der Kollektor-Abbildungsspiegel 46ₙ kann im Bereich zwischen fünf und 25 liegen.

Fig. 11 zeigt eine mögliche Zuordnung Fₙ zwischen Kollektor-Abbildungsspiegeln 46ₙ und Feldfacetten 48ₙ bei einer 3x3-Matrixanordnung sowohl der Kollektor-Abbildungsspiegel 46ₙ als auch der Feldfacetten 48ₙ. Die Ansicht nach Fig. 11 erfolgt mit Blickrichtung längst der optischen Achse oA. Die Kollektor-Abbildungsspiegel 46ₙ sind als größere Quadrate angedeutet und die Feldfacetten 48ₙ als kleinere Quadrate. Ähnlich wie in der Fig. 9 sind auch in der Fig. 11 die Indizes der Kollektor-Abbildungsspiegel 46ₙ als große Zahlen wiedergegeben und die Indizes der Feldfacetten 48ₙ als kleinere und auf dem Kopf stehende Zahlen. Durch gleiche Indizes wird eine Zuordnung des jeweiligen Kollektor-Abbildungsspiegels 46ₙ zur jeweiligen Feldfacette 48ₙ über einen entsprechenden Beleuchtungslicht-Ausleuchtungskanal 35ₙ angedeutet. Dargestellt sind auf den Ausleuchtungskanälen zwischen dem jeweiligen Kollektor-Abbildungsspiegel 46ₙ und der zugeordneten Feldfacette 48ₙ auch der Ort des jeweiligen Zwischenfokus 47ₙ.

Ein Produkt aus dem Kollektor-Ausbildungsmaßstab β_{K} des Kollektor-Abbildungsspiegels 46₁ und dem Facetten-Abbildungsmaßstab β_{F} der zugehörigen Feldfacette unterscheidet sich von einem Produkt aus den Kollektor-Abbildungsmaßstäben β_{K} der weiteren Kollektor-Abbildungsspiegel 46ₙ und den zugehörigen Facetten-Abbildungsmaßstäben β_{F} der Feldfacetten für alle Lichtwege des Beleuchtungslichts 14 hin zu den Pupillenfacetten des Pupillenfacettenspiegels 20 um nicht mehr als einen Faktor 2,5. Dieser Unterschied für die Maßstabsprodukte aus dem Kollektor-Abbildungsmaßstab und dem zugehörigen Facetten-Abbildungsmaßstab kann höchstens 2,25 betragen, höchstens 2,0, höchstens 1,9, höchstens 1,8, höchstens 1,7, höchstens 1,6 oder auch höchsten 1,5, je nach Ausführung des Beleuchtungssystems 45.

Die Feldfacetten des Feldfacettenspiegels 17 nach Fig. 8 gehören zu einer Feldfacetten-Übertragungsoptik, die jeweils einen der Fokusbereich 47ₙ auf eine der Pupillenfacetten des Pupillenfacettenspiegels 20 abbilden.

Zur Herstellung eines nano- bzw. mikrostrukturierten Bauelements, beispielsweise eines Halbleiter-Speicherchips, werden zunächst das Retikel 7 und der Wafer 12 mit einer für das Beleuchtungslicht 14 lichtempfindlichen Beschichtung bereitgestellt. Es wird dann zumindest ein Abschnitt des Retikels 7 auf den Wafer 12 mit Hilfe der Projektionsbelichtungsanlage 1 projeziert. Anschließend wird die mit dem Beleuchtungslicht 14 belichtete lichtempfindliche Schicht auf dem Wafer 12 entwickelt. Mitgeführte Fremdteilchen, die von Komponenten der Strahlungsquelle ausgesandt werden, können im Einschnürungsbereich unterdrückt werden.

## Patentansprüche

1. Beleuchtungssystem (44)
- mit einem Kollektor (45)
- mit einer Beleuchtungsoptik (4), die von dem Kollektor (45) gesammeltes EUV-Beleuchtungslicht (14) hin zu einem Objektfeld (5) führt,
- wobei der Kollektor (45) zur Überführung des EUV-Beleuchtungslichts (14) aus einem Strahlungsquellenbereich (3) hin zu der Beleuchtungsoptik (4) dient,
- wobei die Beleuchtungsoptik (4) aufweist:
-- einen Feldfacettenspiegel (17) mit einer Mehrzahl von Feldfacetten (32),
-- einen Pupillenfacettenspiegel (20) mit einer Mehrzahl von Pupillenfacetten (34), die zu einer Pupillenfacetten-Übertragungsoptik gehören, die die Feldfacetten (32) einander überlagernd in das Objektfeld (5) abbilden,
- wobei der Kollektor (45) eine Kollektor-Abbildungsoptik aufweist, die den Strahlungsquellenbereich (3) in eine Mehrzahl nachgelagerter Fokusbereiche (47ₙ) abbildet, und wobei die Feldfacetten (32) zu einer Feldfacetten-Übertragungsoptik gehören, die jeweils einen der Fokusbereiche (47ₙ) auf eine der Pupillenfacetten (34ₙ) abbildet,
- wobei die Kollektor-Abbildungsoptik so ausgeführt ist,
-- dass mit dem EUV-Beleuchtungslicht (14), das vom Strahlungsquellenbereich (3) mit Strahlwinkeln (α) < 20° zu einer optischen Achse (oA) zwischen dem Strahlungsquellenbereich (3) und einem nachgelagerten ersten Fokusbereich (47₁) emittiert wird, die Strahlungsquelle (3) in den nachgelagerten ersten Fokusbereich (47₁) mit einem ersten Kollektor-Abbildungsmaßstab (β_{K1}) abgebildet wird,
-- dass mit dem EUV-Beleuchtungslicht (14), das vom Strahlungsquellenbereich (3) mit Strahlwinkeln (α) > 70° zu der optischen Achse (oA) zwischen dem Strahlungsquellenbereich (3) und dem nachgelagerten ersten Fokusbereich (47₁) emittiert wird, die Strahlungsquelle (3) in nachgelagerte zweite Fokusbereiche (47₃, 47_{3'}), die räumlich vom ersten Fokusbereich (47₁) getrennt liegen, mit einem zweiten Kollektor-Abbildungsmaßstab (β_{K2}) abgebildet wird,
- wobei die Feldfacetten-Übertragungsoptik so ausgeführt ist,
-- dass der erste Fokusbereich (47₁) mit einem ersten Facetten-Abbildungsmaßstab (β_{F1}) abgebildet wird,
-- dass der zweite Fokusbereich (47₃, 47_{3'}) mit einem zweiten Facetten-Abbildungsmaßstab (β_{F2}) abgebildet wird,
- wobei sich das Produkt (β_{K1} x β_{F1}) aus dem ersten Kollektor-Abbildungsmaßstab (β_{K1}) und dem ersten Facetten-Abbildungsmaßstab (β_{F1}) vom Produkt (β_{K2} x β_{F2}) aus dem zweiten Kollektor-Abbildungsmaßstab (β_{K2}) und dem zweiten Facetten-Abbildungsmaßstab (β_{F2}) für alle Lichtwege (35ₙ) des Beleuchtungslichts (14) hin zu den Pupillenfacetten (34ₙ) um nicht mehr als einen Faktor 2,5 unterscheidet.

2. Kollektor (15; 28; 31; 39; 45) zur Überführung von EUV-Beleuchtungslicht (14) aus einem Strahlungsquellenbereich (3) hin zu einer Beleuchtungsoptik (4), die das EUV-Beleuchtungslicht (14) hin zu einem Objektfeld (5) führt,
- wobei der Kollektor (15; 28; 31; 39; 45) zur reflektierenden Führung des EUV-Beleuchtungslichts (14) mit Einfallswinkeln kleiner als 45° ausgeführt ist,
- wobei der Kollektor (15; 28; 31; 39; 45) eine Kollektor-Abbildungsoptik (26; 46) aufweist, die den Strahlungsquellenbereich (3) in einen nachgelagerten Fokusbereich (25) abbildet,
- wobei die Kollektor-Abbildungsoptik (26) so ausgeführt ist,
-- dass mit dem EUV-Beleuchtungslicht (14), das vom Strahlungsquellenbereich (3) mit Strahlwinkeln (α) < 20° zu einer optischen Achse (oA) zwischen dem Strahlungsquellenbereich (3) und dem nachgelagerten Fokusbereich (25) emittiert wird, die Strahlungsquelle (3) in den nachgelagerten Fokusbereich (25) mit mindestens einem ersten Abbildungsmaßstab (β_{1,20}) abgebildet wird,
-- dass mit dem EUV-Beleuchtungslicht (14), das vom Strahlungsquellenbereich (3) mit Strahlwinkeln (α) > 70° zu einer optischen Achse (oA) zwischen dem Strahlungsquellenbereich (3) und dem nachgelagerten Fokusbereich (25) emittiert wird, die Strahlungsquelle (3) in den nachgelagerten Fokusbereich (25) mit mindestens einem zweiten Abbildungsmaßstab (β_{2,70}) abgebildet wird,
- wobei sich die Abbildungsmaßstäbe (β_{1,20}, β_{2,70}) um nicht mehr als einen Faktor 2,5 unterscheiden.

3. Kollektor nach Anspruch 2, **dadurch gekennzeichnet, dass** die Kollektor-Abbildungsoptik (26) eine Mehrzahl von separat zueinander angeordneten Kollektor-Abbildungsspiegeln (27ₙ; 36ₙ; 46ₙ) aufweist,
- wobei jeder Kollektor-Abbildungsspiegel (27ₙ; 36ₙ; 46ₙ) so ausgeführt ist, dass er EUV-Beleuchtungslicht (14) von dem Strahlungsquellenbereich (3) erfasst, welches in einem Winkelbereich von Strahlwinkeln (α) zu einer optischen Achse (oA) zwischen dem Strahlungsquellenbereich (3) und dem nachgelagerten Fokusbereich (25) emittiert ist,
- wobei der Bereich von Abbildungsmaßstäben (β) jedes Kollektor-Abbildungsspiegels (27ₙ; 36ₙ; 46ₙ) zwischen einem minimalen Abbildungsmaßstab (βₘᵢₙ) und einem maximalen Abbildungsmaßstab (βₘₐₓ) liegt,
- wobei für ein Verhältnis βₘₐₓ/βₘᵢₙ zwischen dem maximalen Abbildungsmaßstab βₘₐₓ und dem minimalen Abbildungsmaßstab βₘᵢₙ gilt: βₘₐₓ/βₘᵢₙ ≤ 2.

4. Kollektor nach Anspruch 3, **dadurch gekennzeichnet, dass** zumindest einige der Kollektor-Abbildungsspiegel (27ₙ) als Ringspiegel ausgeführt sind.

5. Kollektor nach einem der Ansprüche 2 bis 4, **dadurch gekennzeichnet, dass** die Spiegelflächen zumindest einiger der Kollektor-Abbildungsspiegel (27ₙ; 36ₙ; 46ₙ) ellipsoidförmig sind.

6. Kollektor nach einem der Ansprüche 2 bis 5, **gekennzeichnet durch** eine sphärische Optik (29), die den Strahlungsquellenbereich (3) in einen Strahlungsquellen-Bildbereich (3') abbildet, der im Bereich des Strahlungsquellenbereichs (3) liegt.

7. Beleuchtungssystem (2; 30; 44)
- mit einem Kollektor (15; 28; 31; 39; 45) nach einem der Ansprüche 2 bis 6,
- mit einer Beleuchtungsoptik (4),
- mit einem Feldfacettenspiegel (17),
- mit einem Pupillenfacettenspiegel (20),
- wobei im nachgelagerten Fokusbereich (25) eine erste Abbildung des Strahlungsquellenbereichs (3) der Kollektor-Abbildungsoptik (26) im Strahlengang des Beleuchtungslichts (14) nach dem Strahlungsquellenbereich (3) stattfindet,
- wobei der nachgelagerte Fokusbereich (25) im Bereich des Pupillenfacettenspiegels (20) liegt.

8. Beleuchtungssystem nach Anspruch 7, **dadurch gekennzeichnet, dass** zwischen dem Kollektor (31; 39) und einer ersten Komponente (17) der Beleuchtungsoptik (4) ein Einschnürungsbereich (37) liegt, in dem ein Querschnitt eines gesamten Bündels des EUV-Beleuchtungslichts (14) im Vergleich zum Querschnitt auf dem Feldfacettenspiegel (17) um mindestens einen Faktor 2 verringert ist.

9. Beleuchtungssystem nach Anspruch 7 oder 8, **dadurch gekennzeichnet, dass** die Kollektor-Abbildungsoptik (26) eine Mehrzahl von separat zueinander angeordneten Kollektor-Spiegeln (36ₙ) aufweist.

10. Beleuchtungssystem nach Anspruch 9, **dadurch gekennzeichnet, dass** zumindest einige Spiegelflächen (38) der Kollektor-Spiegel (36ₙ) eine Randkontur, die zu einer Randkontur von Feldfacetten (32ₙ) des Feldfacettenspiegels (17) ähnlich ist.

11. Beleuchtungssystem nach Anspruch 9 oder 10, **dadurch gekennzeichnet, dass** die Kollektor-Spiegel (36ₙ) eine rechteckige Randkontur haben.

12. Projektionsbelichtungsanlage (1) mit einem Beleuchtungssystem (2; 30; 44) nach Anspruch 1 oder 7 bis 11 und mit einer EUV-Strahlungsquelle (3).

13. Verfahren zur Herstellung eines nano- beziehungsweise mikrostrukturierten Bauelements mit folgenden Verfahrensschritten:
- Bereitstellen eines Retikels (7),
- Bereitstellen eines Wafers (12) mit einer für das Beleuchtungslicht-Bündel (14) lichtempfindlichen Beschichtung,
- Projizieren zumindest eines Abschnitts des Retikels auf den Wafer (12) mithilfe der Projektionsbelichtungsanlage nach Anspruch 12,
- Entwickeln der mit dem Beleuchtungslicht-Bündel (14) belichteten lichtempfindlichen Schicht auf dem Wafer (12).

## Claims

1. Illumination system (44)
- comprising a collector (45)
- comprising an illumination optical unit (4) which guides EUV illumination light (14) collected by the collector (45) to an object field (5),
- wherein the collector (45) serves to transmit the EUV illumination light (14) from a radiation source region (3) to the illumination optical unit (4),
- wherein the illumination optical unit (4) comprises:
-- a field facet mirror (17) with a plurality of field facets (32),
-- a pupil facet mirror (20) with a plurality of pupil facets (34), which belonged to a pupil facet transfer optical unit which images the field facets (32) in overlaid fashion into the object field (5),
- wherein the collector (45) has a collector imaging optical unit which images the radiation source region (3) into a plurality of downstream focal regions (47ₙ) and wherein the field facets (32) belong to a field facet transfer optical unit which respectively images one of the focal regions (47ₙ) onto one of the pupil facets (34ₙ),
- wherein the collector imaging optical unit is embodied in such a way
-- that the radiation source (3) is imaged into a downstream first focal region (47₁) with a first collector imaging scale (β_{K1}) by way of the EUV illumination light (14), which is emitted by the radiation source region (3) with beam angles (α) <20° with respect to an optical axis (oA) between the radiation source region (3) and the downstream first focal region (47₁),
-- that the radiation source (3) is imaged into downstream second focal regions (47₃, 47_{3'}), which are spatially separated from the first focal region (47₁), with a second collector imaging scale (β_{K2}) by way of the EUV illumination light (14) which is emitted by the radiation source region (3) with beam angles (α) >70° with respect to the optical axis (oA) between the radiation source region (3) and the downstream first focal region (47₁),
- wherein the field facet transfer optical unit is embodied in such a way
-- that the first focal region (47₁) is imaged with a first facet imaging scale (β_{F1}),
-- that the second focal region (47₃, 47_{3'}) is imaged with a second facet imaging scale (β_{F2}),
- wherein the product (β_{K1}×β_{F1}) of the first collector imaging scale (β_{K1}) and the first facet imaging scale (β_{F1}) differs from the product (β_{K2}×β_{F2}) of the second collector imaging scale (β_{K2}) and the second facet imaging scale (β_{F2}) by no more than a factor of 2.5 for all light paths (35ₙ) of the illumination light (14) to the pupil facets (34ₙ).

2. Collector (15; 28; 31; 39; 45) for transmitting EUV illumination light (14) from a radiation source region (3) to an illumination optical unit (4) which guides EUV illumination light (14) to an object field (5),
- wherein the collector (15; 28; 31; 39; 45) is embodied to guide by reflection the EUV illumination light (14) with angles of incidence less than 45°,
- wherein the collector (15; 28; 31; 39; 45) has a collector imaging optical unit (26; 46) which images the radiation source region (3) into a downstream focal region (25),
- wherein the collector imaging optical unit (26) is embodied in such a way
-- that the radiation source (3) is imaged into the downstream focal region (25) with at least one first imaging scale (β_{1,20}) by way of the EUV illumination light (14), which is emitted by the radiation source region (3) with beam angles (α) <20° with respect to an optical axis (oA) between the radiation source region (3) and the downstream focal region (25),
-- that the radiation source (3) is imaged into the downstream focal region (25) with at least one second imaging scale (β_{2,70}) by way of the EUV illumination light (14) which is emitted by the radiation source region (3) with beam angles (α) >70° with respect to an optical axis (oA) between the radiation source region (3) and the downstream focal region (25),
- wherein the imaging scales (β_{1,20}, β_{2,70}) differ by no more than a factor of 2.5.

3. Collector according to Claim 2, **characterized in that** the collector imaging optical unit (26) has a plurality of collector imaging mirrors (27ₙ; 36ₙ; 46ₙ) which are arranged separately from one another,
- wherein each collector imaging mirror (27ₙ; 36ₙ; 46ₙ) is embodied in such a way that it captures EUV illumination light (14) from the radiation source region (3), said EUV illumination light having been emitted in an angular range of beam angles (α) with respect to an optical axis (oA) between the radiation source region (3) and the downstream focal region (25),
- wherein the range of imaging scales (β) of each collector imaging mirror (27ₙ; 36ₙ; 46ₙ) lies between a minimum imaging scale ( βₘᵢₙ) and a maximum imaging scale (βₘₐₓ),
- wherein the following applies to a ratio βₘₐₓ/βₘᵢₙ between the maximum imaging scale βₘₐₓ and the minimum imaging scale βₘᵢₙ: βₘₐₓ/βₘᵢₙ ≤ 2.

4. Collector according to Claim 3, **characterized in that** at least some of the collector imaging mirrors (27ₙ) are embodied as ring mirrors.

5. Collector according to any one of Claims 2 to 4, **characterized in that** the mirror surfaces of at least some of the collector imaging mirrors (27ₙ; 36ₙ; 46ₙ) are ellipsoidal.

6. Collector according to any one of Claims 2 to 5, **characterized by** a spherical optical unit (29) which images the radiation source region (3) into a radiation source image region (3') located in the region of the radiation source region (3).

7. Illumination system (2; 30; 44)
- comprising a collector (15; 28; 31; 39; 45) according to any one of Claims 2 to 6,
- comprising an illumination optical unit (4),
- comprising a field facet mirror (17),
- comprising a pupil facet mirror (20),
- wherein, in the downstream focal region (25), the radiation source region (3) of the collector imaging optical unit (26) is imaged for the first time in the beam path of the illumination light (14) downstream of the radiation source region (3),
- wherein the downstream focal region (25) is located in the region of the pupil facet mirror (20) .

8. Illumination system according to Claim 7, **characterized in that** a constriction region (37) in which a cross section of an entire beam of the EUV illumination light (14) is reduced by at least a factor of 2 in comparison with the cross section in the field facet mirror (17) is located between the collector (31; 39) and a first component (17) of the illumination optical unit (4).

9. Illumination system according to Claim 7 or 8, **characterized in that** the collector imaging optical unit (26) has a plurality of collector mirrors (36ₙ) which are arranged separately from one another.

10. Illumination system according to Claim 9, **characterized in that** at least some mirror surfaces (38) of the collector mirror (36ₙ) an edge contour which is similar to an edge contour of field facets (32ₙ) of the field facet mirror (17).

11. Illumination system according to Claim 9 or 10, **characterized in that** the collector mirrors (36ₙ) have a rectangular edge contour.

12. Projection exposure apparatus (1) comprising an illumination system (2; 30; 44) according to Claim 1 or Claims 7 to 11 and comprising an EUV radiation source (3).

13. Method for producing a nanostructured or microstructured component, including the following method steps:
- providing a reticle (7),
- providing a wafer (12) with a coating that is light-sensitive to the illumination light beam (14),
- projecting at least one section of the reticle onto the wafer (12) with the aid of the projection exposure apparatus according to Claim 12,
- developing the light-sensitive layer on the wafer (12) exposed to the illumination light beam (14).

## Revendications

1. Système d'éclairage (44) comprenant
- un collecteur (45) muni
- d'une optique d'éclairage (4) qui guide la lumière d'éclairage EUV (14) collectée par le collecteur (45) vers un champ objet (5),
- le collecteur (45) servant à transférer la lumière d'éclairage EUV (14) d'une zone source de rayonnement (3) à l'optique d'éclairage (4),
- l'optique d'éclairage (4) comportant :
-- un miroir à facettes de champ (17) pourvu d'une pluralité de facettes de champ (32),
-- un miroir à facettes pupillaires (20) pourvu d'une pluralité de facettes pupillaires (34) qui appartiennent à une optique de transmission à facettes pupillaires et qui reproduisent les facettes de champ (32) en superposition les unes aux autres dans le champ objet (5),
- le collecteur (45) comportant une optique de reproduction de collecteur qui reproduit la zone source de rayonnement (3) dans une pluralité de zones de focalisation (47ₙ) situées en aval, et les facettes de champ (32) appartenant à une optique de transmission de facettes de champ qui reproduit à chaque fois l'une des zones de focalisation (47ₙ) sur l'une des facettes pupillaires (34ₙ),
- l'optique de reproduction de collecteur étant conçue de telle sorte que
-- la source de rayonnement (3) soit reproduite dans la première zone de focalisation (47₁) située en aval avec une première échelle de reproduction de collecteur (β_{K1}) avec la lumière d'éclairage EUV (14), qui est émise par la zone source de rayonnement (3) avec des angles de faisceau (α) < 20° par rapport à un axe optique (oA) entre la zone source de rayonnement (3) et une première zone de focalisation (47₁) située en aval,
-- la source de rayonnement (3) soit reproduite avec une deuxième échelle de reproduction de collecteur (β_{K2}) dans des deuxièmes zones de focalisation (47₃, 47_{3'}), qui sont spatialement séparées de la première zone de focalisation (47₁) avec la lumière d'éclairage EUV (14) qui est émise par la zone source de rayonnement (3) avec des angles de faisceau (α) > 70° par rapport à l'axe optique (oA) entre la zone source de rayonnement (3) et la première zone de focalisation (47₁) située en aval,
- l'optique de transmission à facettes de champ étant conçue de telle sorte que
-- la première zone de focalisation (47₁) soit reproduite avec une première échelle de reproduction à facettes (β_{F1}),
-- la deuxième zone de focalisation (47₃, 47_{3'}) soit reproduite avec une deuxième échelle de reproduction à facettes (β_{F2}),
- le produit (β_{K1} x β_{F1}) de la première échelle de reproduction de collecteur (β_{K1}) et de la première échelle de reproduction à facettes (β_{F1}) ne différant pas de plus d'un facteur 2,5 du produit (β_{K2} x β_{F2}) de la deuxième échelle de reproduction de collecteur (βₖ₂) et de la deuxième échelle de reproduction à facettes (β_{F2}) pour tous les trajets lumineux (35ₙ) de la lumière d'éclairage (14) vers les facettes pupillaires (34ₙ).

2. Collecteur (15 ; 28 ; 31 ; 39 ; 45) destiné à transférer la lumière d'éclairage EUV (14) d'une zone source de rayonnement (3) à l'optique d'éclairage (4), qui guide la lumière d'éclairage EUV (14) vers un champ d'objet (5),
- le collecteur (15 ; 28 ; 31 ; 39 ; 45) destiné au guidage par réflexion de la lumière d'éclairage EUV (14) étant conçu avec des angles d'incidence inférieurs à 45°,
- le collecteur (15 ; 28 ; 31 ; 39 ; 45) comportant une optique de reproduction de collecteur (26 ; 46) qui reproduit la zone source de rayonnement (3) dans une zone de focalisation (25) située en aval,
- l'optique de reproduction de collecteur (26) étant conçue de telle sorte que
-- la source de rayonnement (3) soit reproduite dans la zone de focalisation (25) située en aval avec au moins une première échelle de reproduction (β_{1,20}) avec la lumière d'éclairage EUV (14) qui est émise par la zone source de rayonnement (3) avec des angles de faisceau (α) < 20° par rapport à un axe optique (oA) entre la zone source de rayonnement (3) et la zone de focalisation (25) située en aval,
-- la source de rayonnement (3) soit reproduite dans la zone de focalisation (25) située en aval avec au moins une deuxième échelle de reproduction (β_{2,70}) avec la lumière d'éclairage EUV (14) qui est émise par la zone source de rayonnement (3) avec des angles de faisceau (α) > 70° par rapport à un axe optique (oA) entre la zone source de rayonnement (3) et la zone de focalisation (25) située en aval,
- les échelles de reproduction (β_{1,20}, β_{2,70}) ne différant pas de plus d'un facteur de 2,5.

3. Collecteur selon la revendication 2, **caractérisé en ce que** l'optique de reproduction de collecteur (26) comporte une pluralité de miroirs de reproduction de collecteur (27ₙ ; 36ₙ ; 46ₙ) disposés séparément les uns des autres,
- chaque miroir de reproduction de collecteur (27ₙ ; 36ₙ ; 46ₙ) étant conçu de façon à capter la lumière d'éclairage EUV (14) de la zone source de rayonnement (3) qui est émise dans une plage angulaire d'angles de faisceau (α) par rapport à un axe optique (oA) entre la zone source de rayonnement (3) et la zone de focalisation (25) située en aval
- la zone d'échelles de reproduction (β) de chaque miroir de reproduction de collecteur (27ₙ ; 36ₙ ; 46ₙ) étant située entre une échelle de reproduction minimale (βₘᵢₙ) et une échelle de reproduction maximale (βₘₐₓ),
- βₘₐₓ/βₘᵢₙ ≤ 2 s'appliquant pour un rapport βₘₐₓ/βₘᵢₙ entre l'échelle de reproduction maximale βₘₐₓ et l'échelle de reproduction minimale βₘᵢₙ.

4. Collecteur selon la revendication 3, **caractérisé en ce qu'**au moins certains des miroirs de reproduction de collecteur (27ₙ) sont réalisés sous la forme de miroirs annulaires.

5. Collecteur selon l'une des revendications 2 à 4, **caractérisé en ce que** les surfaces de miroir d'au moins certains des miroirs de reproduction de collecteur (27ₙ ; 36ₙ ; 46ₙ) sont ellipsoïdales.

6. Collecteur selon l'une des revendications 2 à 5, **caractérisé par** une optique sphérique (29) qui reproduit la zone source de rayonnement (3) dans une zone image de source de rayonnement (3') qui est située au niveau de la zone source de rayonnement (3).

7. Système d'éclairage (2 ; 30 ; 44) comprenant
- un collecteur (15 ; 28 ; 31 ; 39 ; 45) selon l'une des revendications 2 à 6,
- une optique d'éclairage (4),
- un miroir à facettes de champ (17),
- un miroir à facettes pupillaires (20),
- dans la zone de focalisation (25) située en aval une première reproduction de la zone source de rayonnement (3) de l'optique de reproduction de collecteur (26) étant effectuée dans le trajet de faisceau de la lumière d'éclairage (14) en aval de la zone source de rayonnement (3),
- la zone de focalisation (25) située en aval étant située dans la zone du miroir à facettes pupillaires (20).

8. Système d'éclairage selon la revendication 7, **caractérisé en ce qu'**une zone de rétrécissement (37), dans laquelle une section transversale d'un faisceau entier de la lumière d'éclairage EUV (14) est réduite d'au moins un facteur 2 par rapport à la section transversale du miroir à facettes de champ (17), est située entre le collecteur (31 ; 39) et un premier composant (17) de l'optique d'éclairage (4).

9. Système d'éclairage selon la revendication 7 ou 8, **caractérisé en ce que** les optiques de reproduction de collecteur (26) comportent une pluralité de miroirs de collecteur (36ₙ) disposés séparément les uns des autres.

10. Système d'éclairage selon la revendication 9, **caractérisé en ce qu'**au moins certaines surfaces de miroir (38) des miroirs de collecteur (36ₙ) un contour de bord qui est similaire à un contour de bord de facettes de champ (32ₙ) du miroir à facettes de champ (17) .

11. Système d'éclairage selon la revendication 9 ou 10, **caractérisé en ce que** les miroirs de collecteur (36ₙ) ont un contour de bord rectangulaire.

12. Système d'éclairage par projection (1) comprenant un système d'éclairage (2 ; 30 ; 44) selon la revendication 1 ou 7 à 11 et une source de rayonnement EUV (3).

13. Procédé de fabrication d'un composant nano- ou micro-structuré, le procédé comprenant les étapes suivantes :
- fournir un réticule (7),
- fournir une plaquette (12) pourvue d'un revêtement photosensible vis-à-vis du faisceau de lumière d'éclairage (14),
- projeter au moins une partie du réticule sur la plaquette (12) à l'aide du système d'éclairage par projection selon la revendication 12,
- développer les couches photosensibles, éclairées avec le faisceau de lumière d'éclairage (14), sur la plaquette (12).
